Europäisches Patentamt

European Patent Office

Office européen des brevets

(19)

(11) Veröffentlichungsnummer : **0 109 568**
**B1**

(12) # EUROPÄISCHE PATENTSCHRIFT

(45) Veröffentlichungstag der Patentschrift :
23.12.87

(51) Int. Cl.⁴ : $H\ 05\ K\ 7/18$

(21) Anmeldenummer : 83110506.9

(22) Anmeldetag : 21.10.83

(54) Schrank oder Gerüst für die Aufnahme von Einschüben elektrischer Anlagen.

(30) Priorität : 22.11.82 DE 3243063

(43) Veröffentlichungstag der Anmeldung :
30.05.84 Patentblatt 84/22

(45) Bekanntmachung des Hinweises auf die Patenterteilung : 23.12.87 Patentblatt 87/52

(84) Benannte Vertragsstaaten :
AT CH DE LI NL SE

(56) Entgegenhaltungen :
CH-A-  516 238
DE-A- 2 639 639
GB-A- 2 052 877
US-A- 3 717 805

(73) Patentinhaber : BBC Aktiengesellschaft Brown,
Boveri & Cie.
Haselstrasse
CH-5401 Baden (CH)

(72) Erfinder : Grass, Hermann
Grenzhofer Strasse 76
D-6803 Edingen (DE)
Erfinder : Beckenbach, Gerhard
Schubertstrasse 2
D-6945 Hirschberg (DE)
Erfinder : Hergert, Gerhard
Merianstrasse 10
D-6940 Weinheim (DE)

(74) Vertreter : Kempe, Wolfgang, Dr. et al
c/o BROWN, BOVERI & CIE AG ZPT Postfach 351
D-6800 Mannheim 31 (DE)

EP 0 109 568 B1

## Beschreibung

Die Erfindung bezieht sich auf einen Schrank oder ein Gerüst für die Aufnahme von in Etagen übereinander und innerhalb einer Etage gegebenenfalls nebeneinander anordenbaren Einschüben für elektrische Schalt-, Steuer-, Überwachungs- und Verteileranlagen, mit im rückseitigen Bereich des Schrankes bzw. Gerüstes angeordneten Stromsammelschienen sowie davor gelegenen vormontierbaren, den einzelnen Einschubetagen gesondert zugeordneten Trägerelementen und mit wenigstens einem in einem seitlichen Bereich des Schrankes bzw. Gerüstes gelegenen, zu den aufzunehmenden Einschüben hin mittels Wandungselementen begrenzten Kabel- und Anschlußraum.

Bereits seit langer Zeit bekannt und bewährt ist die Einschubtechnik in Verbindung mit elektrischen Anlagenschränken. Hierdurch ist eine schnelle Austauschbarkeit einzelner in einem Einschub angeordneter Komponenten möglich, ebenso werden Wartungsarbeiten vereinfacht und auch die Erstmontage sowie die Prüfung der einzelnen in den Einschüben untergebrachten Baugruppen und Funktionskomponenten ist durch diese genannte Technik vereinfachbar. Nach wie vor sind jedoch innerhalb des genannten Anlagenschrankes bzw. Gerüstes sowohl die ganze Verkabelung anzuordnen als auch die mit den einzelnen Einschüben zusammenwirkenden Steckverbindungen ; außerdem sind nicht nur die Netzzuleitung und -verteilung innerhalb des Anlagenschrankes bzw. Gerüstes anzuordnen, sondern auch Anschlußmöglichkeiten für dem Anlagenschrank zuzuführende oder von ihm abzuführende Steuerleitungen sowie von den einzelnen Einschubkomponenten beeinflußbare Leitungen für höhere Stromlasten. Diese genannte Ausrüstung der einzelnen Anlagenschränke bzw. Anlagengerüste kann sehr aufwendig sein, weshalb diese Ausrüstungen in zunehmendem Maße bereits beim Anlagenhersteller erstellt werden anstatt am Aufstellungsort der Anlagen.

Jedoch auch der Aufwand bei einer fabrikseitigen Montage der genannten Verkabelungen, Anschlußsteckelemente, Anschlußklemmen usw. ist sehr aufwendig, da mit zunehmender Anzahl von montierten Bauelementen die Zugänglichkeit unbequemer und die Übersichtlichkeit schwieriger wird. Man ist deshalb bereits dazu übergegangen, Baugruppen und ihre Verdrahtung vorzufertigen und in einer sogenannten Tischverdrahtung vorzumontieren und diese vorgefertigten Montageeinheiten nun innerhalb des zugeordneten Schrankes bzw. Gerüstes komplett einzubringen. Hierbei können bekanntermaßen für jede Einschubetage ein gesondertes Trägerelement vorgesehen werden, welches mit den jeweils zuzuordnenden Zugangs- und Abgangsklemmen und auch Steckerelementen versehen ist, und nun — komplett bestückt — im Schrank bzw. im Gerüst zu montieren ist (DE-OS 29 48 312). Diese bekannten Montageeinheiten haben allerdings den Nachteil, daß sie schlecht lagerfähig sind, da es sich um beiderseits bestückte und wenigstens auf der einen Seite mit einer großen Anzahl von Kabeln und Steuerleitungen versehene Trägerelemente handelt, bei deren Stapelung und Transport innerhalb eines Fabrikgeländes, erst recht aber bei einem Versand durchaus Beschädigungen der Stecker- und Klemmenelemente und Verhaspelungen der Kabelenden und insbesondere der feingliedrigen Steuerleitungen eintreten können. Es ist deshalb erforderlich, nicht nur die Steckerelemente, die Klemmelemente und die gegebenenfalls erforderlichen Verteilerschienen hinreichend zu befestigen, sondern darüberhinaus Befestigungsmaßnahmen in Form von Schellen oder von Bindungen für die einzelnen Kabel- und Leitungsstränge vorzusehen. Selbst die Realisierung solcher Maßnahmen schafft aber noch keinen Schutz für die vormontierten Trägerelemente, so daß deren Bestückung beispielsweise bei der Montage der Schränke im Einzelfall beschädigt oder wenigstens beeinträchtigt werden kann. Außerdem ist es — jedenfalls bei Aufstellungsorten mit relativ starken Beeinträchtigungen durch Luftverschmutzung und dergleichen — häufig unerwünscht, daß Leitungsstränge innerhalb der Schränke oder gar Gerüste ungeschützt sind, d. h. nicht in Kabelkanälen angeordnet oder mit Abdeckungen versehen sind.

Aufgabe der vorliegenden Erfindung ist es, die geschilderten Nachteile zu beseitigen oder wenigstens zu mindern, d. h. für einen Schrank oder ein Gerüst der eingangs genannten Art außerhalb des Schrankes oder Gerüstes vormontierbare und verdrahtbare Trägerelemente zu schaffen, welche die daran zu befestigten Bauelemente sowohl bei der Lagerhaltung als auch beim Transport oder Versand des vormontierten Tragerelementes als auch schließlich bei dessen Montage bzw. bei der Endmontage des jeweiligen Schrankes oder Gerüstes schützt, und in diese Schutzmaßnahmen möglichst auch die Verkabelung der jeweiligen Etage wenigstens weitgehend mit einzubeziehen.

Die Lösung dieser Aufgabe wird erfindungsgemäß dadurch erzielt, daß sowohl die den einzelnen Einschubetagen zugeordneten Trägerelemente als auch die den Kabel- und Anschlußraum zu den aufzunehmenden Einschüben hin begrenzenden Wandungselemente eine kastenförmige Ausbildung erhalten und mit das Kasteninnere im wesentlichen verschließenden Abdeckungen ausgestattet werden, daß jedem kastenförmigen Trägerelement außerdem wenigstens ein gesondertes, ebenfalls kastenförmiges Wandungselement zur Begrenzung des Kabel- und Anschlußraumes zugeordnet wird und daß schließlich die in einer gemeinsamen Etage angeordneten kastenförmigen Elemente in ihrer im Schrank bzw. im Gerüst montierten Lage hinsichtlich ihrer Längserstreckung rechtwinkelig zueinander und aneinanderstoßend zusammengefügt werden, wobei Ausnehmungen innerhalb beider aneinanderstoßenden Kastenwandungsbereiche Durchtrittsöffnungen für den Durchtritt der Leitungselemente vom Inneren des Trägerelementes in das Innere der zugeordneten Wandungselemente bilden. Die kastenförmige Ausbildung der Trägerelemente und auch der besagten Wandungselemente mag zwar aufwendiger sein als eine ebene Ausbildung, sie bringt jedoch mannigfache Vorteile mit sich, nicht zuletzt den einer größeren Steifigkeit dieser Elemente. Nicht unterschätzt werden darf auch der Vorteil der weitgehend berührungssicheren Unterbringung und Halterung von Stromverteilerschienen und Kabeln im Trägerelement bzw. von Verkabelungen und Anschlußelementen im Inneren der Wandungselemente, wie solches in einem Weiterbildungsvorschlag unterbreitet wird.

Zweckmäßigen Ausgestaltungen zufolge wird weiterhin vorgeschlagen, die kastenförmigen Trägerelemente als Kunststofformteile auszubilden, die zugeordneten kastenförmigen Wandungselemente hingegen als erdungsfähige Blechformteile zu gestalten. Bei Trägerelementen in Form von Kunststofformteilen ist es — gemäß einem zweckmäßigen Weiterbildungsvorschlag — in besonders einfacher Weise möglich, in ihrem Inneren Rippen vorzusehen, zwischen denen die Stromverteilerschienen einfügbar sind oder an denen sie zu ihrer Lagefixierung anschlagen können. Hierdurch ist die Montage der Stromverteilerschienen besonders einfach und dennoch zuverlässig, wobei auch Wärmedehnungen der Stromverteilerschienen problemlos beherrscht und aufgefangen werden können.

Entsprechend einer anderen zweckmäßigen Weiterbildung des Erfindungsgedankens wird vorgeschlagen, die Tragelemente mit rohrartigen Ausformungen zu versehen, welche in montierter Lage zu den Stromsammelschienen gerichtet sind und innerhalb derer elektrisch mit den Stromverteilerschienen einerseits verbundene und mit den Stromsammelschienen andererseits verbindbare Anschlußkontaktelemente anordenbar sind. Durch diese Ausformungen werden die Kontaktverbindungen, welche vorzugsweise als Steckverbindungen ausgebildet sind, schützend umgeben.

Ebenfalls vorteilhaft ist derjenige Ausgestaltungsvorschlag, wonach die kastenförmigen Trägerelemente in den Randbereichen ihrer umlaufenden Kastenwandungen Rastöffnungen enthalten, welche mit Rastnasen an den zugeordneten Abdeckungen zusammenwirken, oder stattdessen eine umgekehrte Anordnung vorzusehen, nämlich an den genannten Kastenwandungen federnde Rastnasen anzuformen, welche mit entsprechenden Rastöffnungen in den Abdeckungen zusammenwirken können. Hierdurch ist außer einer vereinfachten Montage eine genaue Lagefixierung der Abdeckungen möglich oder auch eine zusätzliche Halterung zu vorgesehenen weiteren Befestigungsmaßnahmen. Zur Verwirklichung solcher Befestigungsmaßnahmen wird zufolge einer weiteren vorgeschlagenen Ausgestaltung vorgesehen, die kastenförmigen Trägerelemente in ihrem Inneren mit Hülsen oder (gegebenenfalls auch eingespritzten metallischen) Gewindebuchsen zur Aufnahme von Befestigungsschrauben auszustatten. Als Befestigungsschrauben können, je nach Ausbildung und Bestückung der genannten Hülsen, entweder selbstschneidende Schrauben oder normale metrische Schrauben Verwendung finden.

Eine sehr wesentliche Weiterbildung des Erfindungsgedankens ist in dem Vorschlag zu sehen, die Abdeckungen der einzelnen Trägerelemente in Abhängigkeit von der Anzahl der in der entsprechenden Etage aufzunehmenden Einschübe ein- oder mehrteilig auszubilden, wobei jedem der Einschübe ein gesondertes Abdeckteil zugeordnet wird. Anders als bei bekannten Vorrichtungen findet hier also stets ein und dasselbe Trägerelement Verwendung und die Anpassung an mehrere schmale Einschübe oder stattdessen wenige breitere oder stattdessen an einen ganz breiten Einschub erfolgt hier also durch die Abdeckungen, welche sich aus — wie eben bereits gesagt — jeweils einem oder mehreren Abdeckteilen für jedes Trägerelement zusammensetzen.

Auch diese Abdeckteile für die Abdeckung der kastenförmigen Trägerelemente können vorteilhafterweise als Kunststofformteile ausgebildet sein. Hierbei ist es zweckmäßig, ihre in montierter Lage dem zugeordneten Trägerelement zugewandten oberen und/oder unteren Kanten mit winkeligen Anformungen zu versehen, von welchen federnde Rastnasen ausgehen oder in welchen Rastöffnungen zur Aufnahme von Rastnasen angeordnet sind, dis von den Trägerelementen selbst ausgehen, wie dieses oben bereits angedeutet worden ist.

Weitere vorteilhafte Ausbildungen bzw. Ausgestaltungen insbesondere der einzelnen Abdeckteile sind den Ansprüchen 10 bis 13 zu entnehmen.

Auch für die kastenförmigen Wandungselemente werden vorteilhafte Ausbildungen vorgeschlagen, nämlich beispielsweise ihre Kastenboden-Fläche mit Ausnehmungen zur vorzugsweise rastenden Aufnahme von Steckanschlußelementen oder Anschlußklemmen zu versehen. Diese Ausnehmungen können übrigens entsprechend dem jeweiligen Bedarfsfall in kleinerer oder größerer Anzahl und/oder auch Ausdehnung bzw. Breite austrennbar sein, was so verwirklicht werden sollte, daß zur Austrennung lediglich einfache Werkzeuge nötig sind. Derartige Maßnahmen erlauben die unterschiedlichsten Bestückungen der kastenförmigen Wandungselemente, wobei auch hier der Vorteil zu nennen ist, daß die ins Kasteninnere der Wandungselemente weisenden Anschlußklemmenbereiche bzw. Steckanschlußelemente sowie die zugeführten Kabel und Litzen im Kasteninneren eingefangen und somit auch in besonderer Weise geschützt sind.

Weitere vorteilhafte Ausgestaltungen der kastenförmigen Wandungselemente sowie der diesen zugeordneten Abdeckungen sind den Ansprüchen 19 bis 21 zu entnehmen.

Anhand figürlicher Darstellungen und der nachfolgenden Beschreibung dieser Darstellungen sollen der Erfindungsgedanke und einige vorteilhafte Ausgestaltungsmoglichkeiten noch einmal erläutert und verdeutlicht werden. Es zeigt :

Figur 1 in perspektivischer und zugleich weitgehend vereinfachter Darstellung eine Sicht in einen Anlagenschrank mit den wesentlichsten erfindungsgemäßen Baugruppen,

Figur 2 ebenfalls in perspektivischer Sicht eine Explosionsdarstellung aller erfindungswesentlicher Teile für eine Schranketage,

Figur 3 in etwas verkleinertem Maßstab die in Figur 2 dargestellten Teile in ihrer miteinander montierten Lage und

Figur 4 einen teilweise schematisierten Querschnitt durch ein erfindungsgemäßes Trägerelement mit darin sichtbarer Verkabelung.

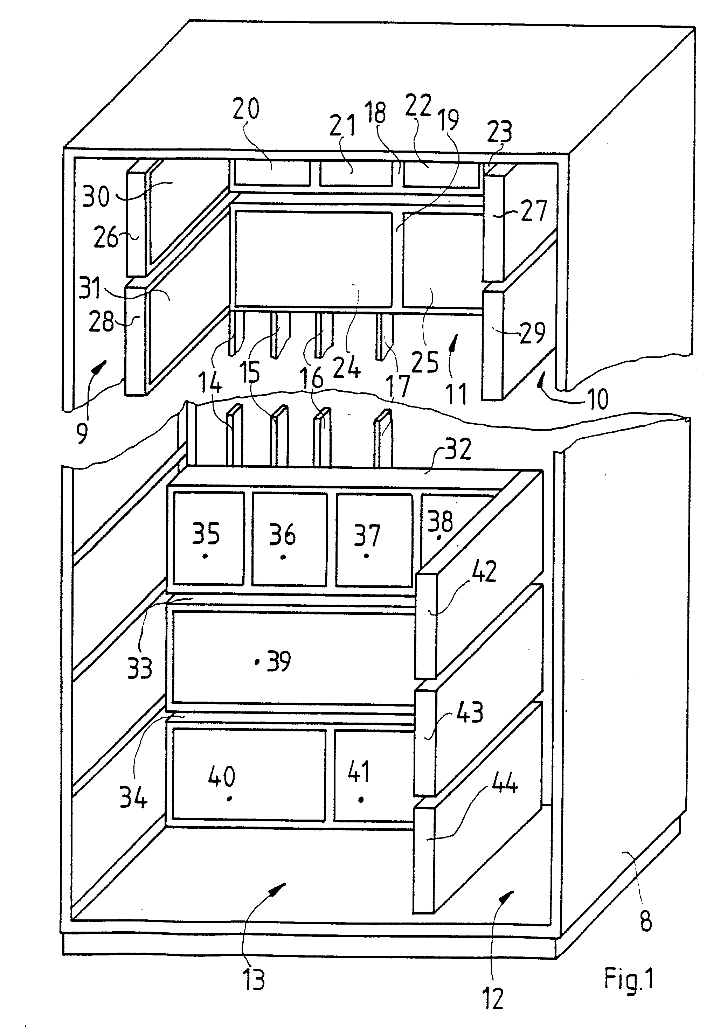

Die Figur 1 veranschaulicht eine Sicht in einen horizontal ausgebrochenen Anlagenschrank 8 der zur Rede stehenden Art, wobei der in der Darstellung obere Schrankbereich zwei seitliche Kabel- und Anschlußräume 9 und 10 mit vergleichsweiser schmaler Bemessung und einen dazwischenliegenden Einschubbereich 11 aufweist, der darunterliegende Schrankbereich hingegen enthält nur einen, dafür aber breiteren seitlichen Kabel- und Anschlußraum 12 und ebenfalls einen Einschubbereich 13, dessen Breite derjenigen des oben dargestellten Einschubbereiches 11 entspricht. Im oben dargestellten Schrankbereich sind vier Stromsammelschienen 14, 15 ; 16 und 17 erkennbar, welche hinter Trägerelementen 18 und 19 für die obersten beiden Einschubetagen verlaufen. Diese Trägerelemente sind kastenartig ausgebildet und weisen nach vorne zu den aufzunehmenden (nicht angedeuteten) Einschüben gerichtete Abdeckungen auf, wobei sich diejenige für das zuoberst gelegene Trägerelement 18 aus den Abdeckteilen 20, 21, 22 und 23 zusammensetzt und diejenige für das daruntergelegene Trägerelement 19 aus den Abdeckteilen 24 und 25. Die Anzahl der Abdeckteile richtet sich hierbei nach der Anzahl der aufzunehmenden Einschübe, d. h. also die oberste Etage ist für vier schmale Einschübe vorgesehen, die zweitoberste hingegen für zwei breitere Einschübe. Seitlich der Trägerelemente 18 und 19 sind ebenfalls kastenförmig ausgebildete Wandungselemente zur Begrenzung der Kabel- und Anschlußräume 9 und 10 angeordnet und mit den Ziffern 26 und 27 (für die oberste Etage) sowie 28 und 29 (für die darunterliegende Etage) versehen. Auch diese kastenförmige Wandungselemente 26 bis 29 sind mit das Kasteninnere verschließenden Abdeckungen versehen, von denen jedoch infolge der perspektivischen Darstellung lediglich diejenigen für die Wandungselemente 26 und 28 erkennbar und mit den Ziffern 30 und 31 gekennzeichnet sind.

Im dargestellten unteren Teil des Anlagenschrankes 8 finden sich wieder die bereits genannten Stromsammelschienen 14 bis 17 wieder und auch hier sind davor liegende Trägerelemente 32, 33 und 34 erkennbar, von denen das zuoberst dargestellte Trägerelement 32 mit insgesamt vier Abdeckteilen 35 bis 38 (also für vier Einschübe) versehen ist, das darunterliegende Trägerelement 33 mit nur einem Abdeckteil 39 (für nur einen aufzunehmenden Einschub) und das zuunterst gelegene Trägerelement 35 schließlich mit zwei Abdeckteilen 40 und 41 (d. h. also für zwei Einschübe).

Wie bereits oben ausgeführt, ist im unteren Bereich des dargestellten Anlagenschrankes 8 lediglich ein seitlicher Kabel- und Anschlußraum 12 vorhanden und dementsprechend ist den Trägerelementen 32 bis 34 auch lediglich je ein kastenartiges Wandungselement zugeordnet, d. h. also dem Trägerelement 32 das Wandungselement 42, dem darunterliegenden Trägerelement 33 das Wandungselement 43 und schließlich das Wandungselement 44 für das zuunterst gelegene Trägerelement 34.

Wie bei der Figurenaufzählung schon angedeutet, ist die Darstellung in dieser Figur 1 weitgehend schematisiert werden und dient lediglich dem Zweck, die räumliche Aufteilungsmöglichkeit eines derartigen Anlagenschrankes und die Lage der darin angeordneten Trägerelemente und Wandungselemente anzudeuten. Ausbrüche, ins Einzelne gehende Ausformungen und an diesen Elementen angeordnete bzw. aus ihnen herausragende Teile wie Anschlußklemmen, Steckanschlußelemente und dergleichen sind aus dieser Darstellung nicht zu entnehmen. Verzichtet worden ist auch auf die Andeutung von Halterungen für diese Elemente oder Halterungen und Führungen für die aufzunehmenden Schübe. Erkennbar ist hingegen, daß jedem kastenförmigen Trägerelement, je nach dem, ob zwei seitliche Kabel- und Anschlußräume (wie im oberen Teil der Darstellung) oder lediglich ein solcher Anschlußsraum (entsprechend der unteren Darstellung) gebildet werden sollen, ein bzw. zwei gesonderte kastenförmige Wandungselemente zugeordnet sind. Erkennbar ist schließlich auch, daß die in einer gemeinsamen Etage angeordneten kastenförmigen Elemente in ihrer im Schrank montierten Lage hinsichtlich ihrer Längserstreckung rechtwinkelig zueinander und angenähert aneinanderstoßend zusammengefügt sind. Erwähnt darf hierbei werden, daß Ausnehmungen innerhalb der aneinanderstoßenden Kastenwandungsbereiche Durchtrittsöffnungen vom Inneren des Trägerelementes zum Inneren des bzw. der zugeordneten Wandungselemente bilden, was aber aus dieser Darstellung nicht zu entnehmen ist. Schließlich darf zu dieser Darstellung angemerkt werden, daß man in der Praxis in aller Regel jeweils entweder einen einzigen durchgehenden seitlichen Kabel- und Anschlußraum vorsehen wird, oder stattdessen, wie im oberen Teil der Figur 1 gezeigt worden ist links und rechts je einen Kabel- und Anschlußraum, nicht aber, wie diese Darstellung vermuten läßt, streckenweise zwei solche Anschlußräume und in den übrigen Schrankbereichen nur einen Kabel- und Anschlußraum.

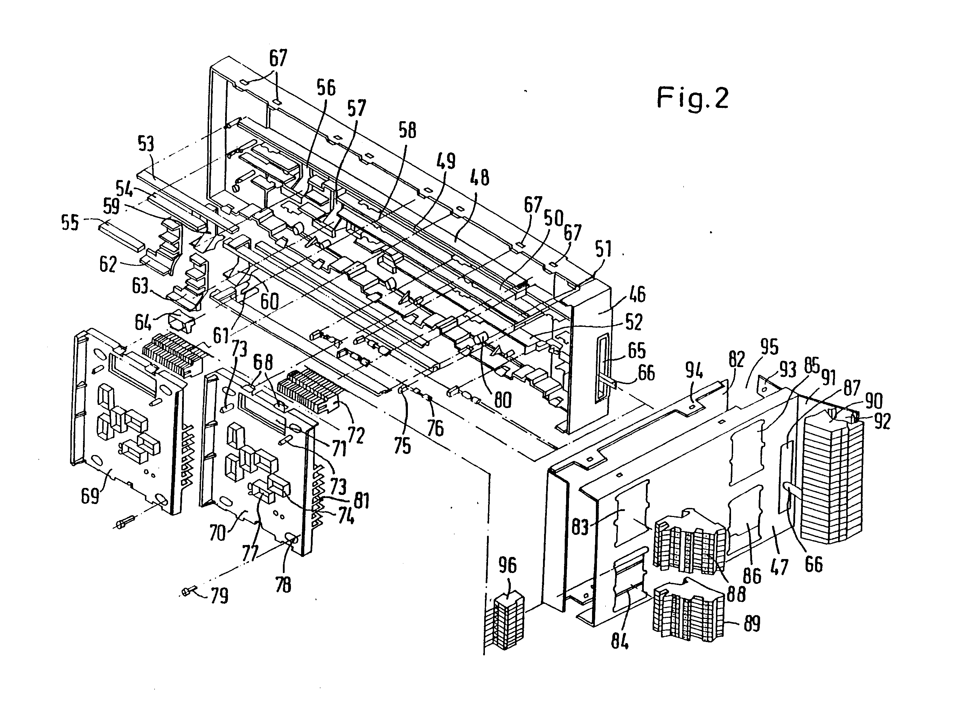

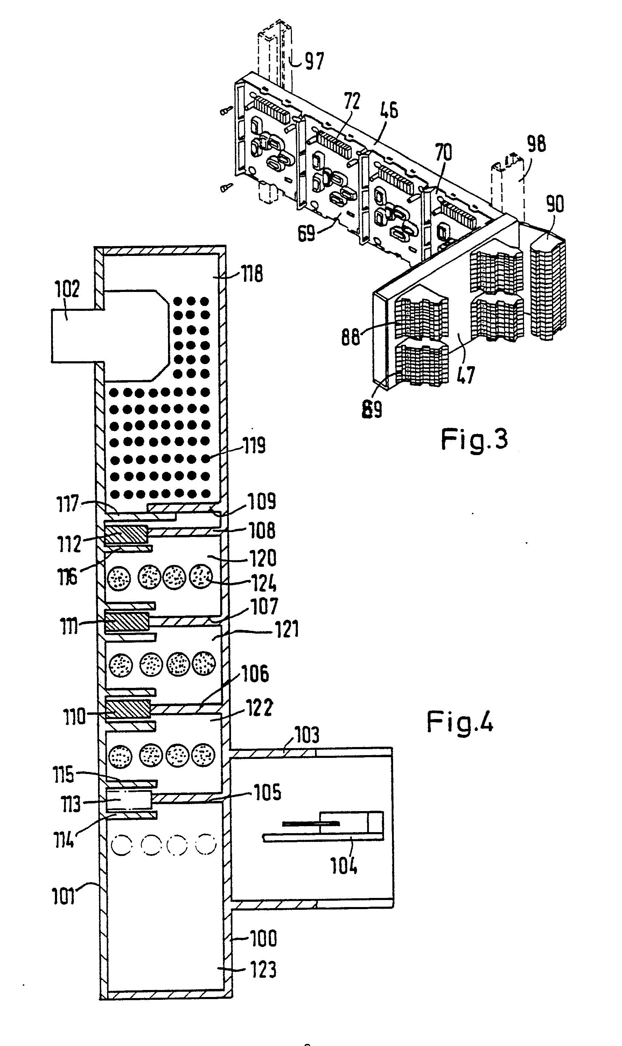

Figur 2 zeigt nun — in perspektivischer Explosionsdarstellung — ein kastenförmiges Trägerelement 46 sowie ein zugeordnetes kastenförmiges Wandungselement 47 mit den jeweils zugehörigen Bauelementen und Teilen, und zwar nunmehr in weitgehend wirklichkeitsgetreuer Ausführung. Erkennbar ist, daß im Inneren des kastenförmigen Trägerelementes 46 mannigfache Rippen, beispielsweise die Rippen 48 bis 52 ausgeformt sind, welche der Abstützung und Lagefixierung von Verteilerschienen 53, 54 und 55 dienen, außerdem aber auch der Bildung von einzelnen Kanälen bzw. Aufnahmeräume für Leistungs- und Steuerkabel, worauf im Zusammenhang mit den Erläuterungen zur Figur 4 noch näher eingegangen werden soll. Im übrigen ist das Trägerelement 46 mit mehreren Durchbrüchen versehen, welche der Einführung oder stattdessen der Herausführung von Anschlußelementen bzw. Kabeln dienen. Erkennbar sind Durchbrüche 56, 57 und 58, durch welche von den bereits genannten Verteilerschienen 53, 54 und 55 ausgehende Schienenanschlußelemente 59, 60 und 61 treten und mit (in dieser Darstellung nicht angedeuteten) Stromsammelschienen verbunden werden können. Zur schützenden Abdeckung dieser Schienenanschlußelemente 59, 60 und 61 dienen Abdeckformteile 62, 63 und 64, welche es verhindern, daß die besagten Schienenanschlußelemente von der Einschubseite her beeinträchtigt werden können. Ein weiterer Durchbruch 65 in der zum Wandungselement 47 gerichteten Seitenwandung des Trägerelementes 46 dient der Durchführung von Kabeln und Steuerleitungen in das Innere des Wandungselementes 47. Angedeutet ist ein einziges Kabel 66, welches stellvertretend für ein ganzes Bündel von Kabeln und Steuerleitungen dargestellt ist. In seiner in der Darstellung nach oben weisenden Seitenwandung des Trägerelementes 46 sind ebenfalls Öffnungen, nämlich kleine Rastöffnungen 67 angeordnet, welche mit federnden Rasthaken 68 an Abdeckteilen 69 und 70 für das Trägerelement 46 zusammenwirken.

Da dieses Trägerelement 46 für die Kombination mit lediglich einem Wandungselement 47 vorgesehen ist, weist die andere, in der Darstellung nach links oben weisende Seitenwandung des Trägerelementes 46, welche derjenigen mit dem Durchbruch 65 gegenüber liegt, keinen erkennbaren Durchbruch auf. Ein solcher wäre aber anzuordnen bzw. auszubrechen, falls es vorgesehen wäre, auch an jene Seitenwandung ein kastenförmiges Wandungselement anzugliedern. Schließlich zur in der Darstellung nach unten weisenden Seitenwandung des Trägerelementes 46 : diese untere Kastenwandung ist nicht eben, sondern vielmehr in eigener Weise profiliert ausgebildet, was mit der Ausbildung, Halterung und Führung der anzugliedernden Einschübe zusammenhängt. Einzelheiten hierzu sind im vorliegenden Falle nicht von Interesse, es sei nur erwähnt, daß vergleichbare Ausformungen sich auch an den in der Darstellung nach unten gerichteten Kanten der bereits erwähnten Abdeckteile 69 und 70 wiederfinden.

Im dargestellten Ausführungsbeispiel ist es vorgesehen, das Trägerelement 46 mit einer Abdeckung zu versehen, welche sich aus insgesamt vier einzelnen Abdeckteilen, je einem für einen anzugliedernden schmalen Einschub, zusammensetzt. Der Übersichtlichkeit halber sind hiervon jedoch nur zwei, nämlich die genannten Abdeckteile 69 und 70 dargestellt, die im übrigen einander völlig gleichen. Erkennbar ist, daß diese Abdeckteile 69 und 70 in ihrem oberen Bereich außer den schon genannten Rasthaken 68 noch einen Ausbruch 71 für die Aufnahme eines Steckanschlußelementes 72 aufweisen, welch letzteres hierin rastend oder auf sonst bekannte Weise befestigt ist. Weiterhin weisen die Abdeckteile 69 und 70 vorstehende Führungsstifte 73 auf, welche der präzisen Einführung des jeweils zugeordneten Einschubes kurz vor dem Kontaktieren der Steckanschlußelemente 72 dienen. Für den Durchtritt der erforderlichen Leistungszugänge und Leistungsabgänge sind zwei Gruppen von je drei Rechtecköffnungen vorgesehen, von denen jedoch der lediglich eine mit der Ziffer 74 gekennzeichnet ist. Hierbei sind die drei jeweils links stehenden und mit ihren Breitseiten vertikal gestellten Rechtecköffnungen dem Leistungszugang über die bereits genannten Verteilerschienen 53, 54 und 55 zugeordnet, die anderen Rechtecköffnungen (74) hingegen dem Leistungsabgang, wobei letzterem die angedeuteten Stiftkontakte 75 zugeordnet sind, welche — wie auch die Verteilerschienen 53, 54 und 55 — ebenfalls innerhalb des Trägerelementes 46 angeordnet und mit Kabeln 76 kombiniert sind. Erwähnenswert ist es, daß die genannten Rechtecköffnungen 74 mit in Richtung der anzugliedernden Einschübe vorstehenden, rundum laufenden Kragen 77 versehen sind, welche nicht nur dem Schutz und der Verstärkung der Randungen der Rechtecköffnungen 74 dienen, sondern gleichzeitig auch als Einführhilfe und Führung für die von den Einschüben ausgehenden Enden der (nicht dargestellten) schienenartigen Leistungskontaktelementen. Außerdem aber dienen diese Kragen 77 zur Erhöhung der Berührungssicherheit und nicht zuletzt der Vergrößerung der Luft- und Kriechstrecken.

Zu nennen sind noch Befestigungsöffnungen 78 mit zugeordneten Schraubelementen 79 zur Schraubbefestigung der Abdeckteile 69 und 70 am Trägerelement 46. Für diese Schraubbefestigung sind innerhalb des Trägerelementes 46 Hülsen 80 und gegebenenfalls darin eingeformte metallische Muttern angeordnet bzw. vom Trägerelement 46 ausgeformt. Die bezifferte Hülse 80 ist hierbei dem Abdeckteil 69 zugeordnet. Übrigens können diese Hülsen 80 auch anstatt der Schraubbefestigung nur der Führung der Abdeckteile 69, 70 dienen. Schließlich seien von den Abdeckteilen 69 und 70 ausgehende und in Richtung des Trägerelementes 46 weisende Rippen 81 genannt, zwischen denen die bereits genannten Verteilerschienen 53, 54 und 55 ihre Aufnahme finden. Die Anformung dieser Rippen 81 an den Abdeckteilen 69, 70 hat den besonderen Vorteil, daß unerwünschte Versetzungen der Verteilerschienen 53, 54 und 55 zu den ihnen zugeordneten Rechtecköffnungen 74 praktisch ausgeschlossen sind, selbst dann, wenn die Lage der einzelnen Abdeckteile zum Trägerelement 46 geringfügig aus der Sollage verschoben wäre.

Dieses Trägerelement 46 mitsamt seiner Abdeckung mittels den Abdeckteilen 69, 70 wird nun, wie bereits im unteren Teil der Fig. 1 schematisch angedeutet, mit dem schon genannten Wandungselement 47 kombiniert. Dieses Wandungselement 47 weist, ähnlich wie das Trägerelement 46, eine kastenartige Formgebung auf und ist mit einem Abdeckteil 82 verschließbar. Erkennbar ist, daß das Wandungselement 47 auf seiner zum Kabel- und Anschlußraum gerichteten Wandung Ausbrüche 83 bis 87 aufweist, von denen die Ausbrüche 83 bis einschl. 86 der rastenden Aufnahme von paketierten oder jedenfalls aneinander fügbaren Steuersteckern (dargestellt sind zwei Pakete 88 und 89 von Steuersteckern) dienen, der Ausbruch 87 hingegen der Durchführung von Kabeln (erkennbar ist die zwischendurch unterbrochene Fortsetzung des bereits am Trägerelement 46 in dessen Durchbruch 65 angedeuteten Kabels 66), welche zu Leistungsklemmen 90 führen. Diese Leistungsklemmen 90 sind an einer aus der Grundfläche des Wandungselementes 47 ausgebogenen Tragwandung 91 über eine Hutprofilschiene 92 befestigt. Es darf angemerkt werden, daß sich in der Grundfläche des Wandungselementes 47 weitere Ausbrüche für Steuerstecker oder dergleichen anbringen lassen, allerdings ist bei einer zu dichten Bestückung dieser Wandung mit Stecker- und Klemmelementen die Zugänglichkeit etwas beschwert.

Vom kastenförmigen Wandungselement 47 gehen außerdem Befestigungslaschen 93 aus, welche der Verbindung entweder mit dem Trägerelement 46 oder mit im Schrank bzw. Gerüst vorgesehenen Trägern oder Schienen dienen. Auch das Abdeckteil 82 weist Laschen 94 auf, welche ihrer rastenden und/oder mittels Schraubelementen bewirkten Halterung am Wandungselement 47 dienen. Bemerkenswert ist, daß das Abdeckteil 82 an seinem in der Darstellung nach rechts oben weisenden Ende wenigstens streckenweise kürzer ausgebildet ist als das Wandungselement 47, so daß in montierter Lage dieser beiden Teile ein offener Durchtrittsbereich 95 verbleibt, durch welchen die vorher bereits genannten Kabel 66 ungehindert zu den Leistungsklemmen 90 geführt werden können.

Nicht unerwähnt bleibe, daß auch innerhalb des kastenförmigen Wandungselementes 47 Anschlußklemmen oder ähnliche Elemente angeordnet werden können, beispielsweise ein Paket von Steckklemmen 96, wie es links neben dem Wandungselement 47 angedeutet worden ist.

Eine perspektivische Sicht auf das komplett montierte Trägerelement 46 und das angegliederte Wandungselement 47 veranschaulicht (in geringfügig verkleinertem Maßstab gegenüber der Darstellung in Fig. 2) dis Figur 3. Erkennbar sind hier die bereits ausführlich beschriebenen Abdeckteile 69 und 70 sowie die beiden übrigen in der Fig. 2 weggelassenen (und hier nicht mehr bezifferten) Abdeckteile mit den daran angeordneten Steckanschlußelementen 72. Am Wandungselement 47 sind nun auch außer den Leistungsklemmen 90 die Steuerstecker-Pakete 88 und 89 sowie zwei weitere Pakete von Steuersteckern erkennbar. In dieser Darstellung ist weiterhin angedeutet, wie sich das Trägerelement 46 innerhalb des aufnehmenden Anlagenschrankes befestigen läßt, nämlich beispielsweise über vertikal verlaufende Profilträger 97 und 98.

Von außen nicht sichtbar sind die Verteilerschienen und die gesamte Verkabelung innerhalb des Trägerelementes 46 und des Wandungselementes 47, hierin liegt aber gerade ein wesentlicher Vorteil dieser kompletten Baugruppen.

Wie und in welch vorteilhafter Weise diese Verkabelung innerhalb eines Trägerelementes angeordnet sein kann, veranschaulicht die weitgehend schematisierte und vereinfachte Schnittdarstellung der Figur 4. Gezeigt ist ein Trägerelement 100 mit einer Abdeckung 101, aus welcher ein Steckanschlußelement 102 herausragt. Vom Trägerelement 100 geht eine Ausformung 103 zur Aufnahme eines Schienenanschlußelementes 104 aus. Dieses Schienenanschlußelement 104 ragt durch eine Öffnung in das Innere des Trägerelementes 100, was jedoch aus dieser Darstellung nicht zu entnehmen ist. Innerhalb des Trägerelementes 100 sind Rippen 105 bis 109 angeformt, welche der Abstützung und Lagefixierung von Verteilerschienen 110, 111 und 112 dienen und notwenigenfalls auch einer weiteren Verteilerschiene, wofür ein zusätzlicher Freiraum 113 vorgesehen ist. Diese Verteilerschienen 110 bis 112 und gegebenenfalls eine im Freiraum 113 angeordnete weitere Verteilerschiene ruhen zwischen Rippenpaaren 114/115 bzw. die zuoberst angeordnete Verteilerschiene 112 zwischen einem Rippenpaar 116/117, welche allesamt von der Abdeckung 101 ausgehen. Ersichtlich ist, daß die Rippe 117 höher ausgebildet als die mit ihr korrespondierende Rippe 116 und zusammen mit der Rippe 109 des Trägerelementes 100 einen (in der Darstellung) darüberliegenden Kabelraum 116 für darin angeordnete Steuerleitungen 119 bildet, welcher zu den daruntergelegenen Verteilerschienen 110 bis 112 weitgehend verschlossen ist. Aber auch zwischen den einzelnen Verteilerschienen 110 bis 112 bzw. den angrenzenden Rippenpaaren 114 und 115 sind Kabelkanäle gebildet, zu deren Begrenzung die oben bereits genannten Rippen 105 bis 108 beitragen. Innerhalb dieser mit den Ziffern 120 bis 123 gekennzeichneten Kabelkanäle sind nun jeweils mehrere Leistungskabel anordenbar, beispielsweise im Kabelkanal 120 die Leistungskabel 124. Hierbei handelt es sich vorzugsweise um von den einzelnen Einschüben ausgehende Leistungsabgänge, wobei es zweckmäßig aber nicht dringend erforderlich ist, daß in ein und demselben Kabelkanal Leistungskabel gleichen Potentials angeordnet werden.

Wie ersichtlich, ist der zuunterst gelegene Kabelkanal 123 besonders geräumig ; es ist ohne weiteres möglich, ihn durch Anordnung weiterer entweder vom Tragelement 100 oder von dessen Abdeckung 101 ausgehender Rippen gegebenenfalls sogar mehrfach zu unterteilen, wodurch sich zusätzliche Möglichkeiten zur Untergliederung der einzelnen Leitungsgruppen eröffnen.

Auf diese Weise ist nicht nur eine weitgehend verschmutzungsfreie und gegen äußere mechanische Einwirkungen geschützte Unterbringung der gesamten erforderlichen Verkabelung für die zuzuordnenden Einschübe geschaffen, sondern darüberhinaus auch noch eine Separierung einzelner Leitungsgruppen.

**Patentansprüche**

1. Schrank oder Gerüst für die Aufnahme von in Etagen übereinander und innerhalb einer Etage gegebenenfalls nebeneinander anordenbaren Einschüben für elektrische Schalt-, Steuer-, Überwachungs und Verteileranlagen, mit im rückseitigen Bereich des Schrankes beziehungsweise Gerüstes angeordneten Stromsammelschienen sowie davor gelegenen vormontierbaren, den einzelnen Einschubetagen gesondert zugeordneten Trägerelementen und mit wenigstens einem in einem seitlichen Bereich des Schrankes beziehungsweise Gerüstes gelegenen, zu den aufzunehmenden Einschüben hin mittels Wandungselementen begrenzten Kabel- und Anschlußraum, dadurch gekennzeichnet, daß sowohl die den einzelnen Einschubetagen zugeordneten Trägerelemente (18, 19 ; 32, 33, 34 ; 46 ; 100) als auch die den Kabel- und Anschlußraum (9, 10, 12) zu den aufzunehmenden Einschüben hin begrenzenden Wandungselemente (26 ... 29 ; 42, 43, 44 ; 47) eine kastenförmige, der Aufnahme von elektrischen Leitungselementen dienende Ausbildung aufweisen und mit das Kasteninnere im wesentlichen verschließenden Abdeckungen (20 ... 25 ; 30, 31 ; 35 ... 41 ; 69, 70 ; 82 ; 101) ausgestattet sind, daß jedem kastenförmigen Trägerelement wenigstens ein gesondertes kastenförmiges Wandungselement zugeordnet ist und daß die in einer gemeinsamen Etage angeordneten kastenförmigen Elemente in ihrer im Schrank (8) beziehungsweise im Gerüst montierten Lage hinsichtlich ihrer Längserstreckung rechtwinkelig zueinander und aneinanderstoßend zusammengefügt sind, wobei Ausnehmungen (65, 95) innerhalb beider aneinanderstoßenden Kastenwandungsbereiche Durchtrittsöffnungen für den Durchtritt der Leitungselemente vom Inneren des Trägerelementes in das Innere der zugeordneten Wandungselemente bilden.

2. Schrank oder Gerüst nach Anspruch 1, dadurch gekennzeichnet, daß im Inneren der kastenförmigen Trägerelemente (18, 19 ; 32, 33, 34 ; 46 ; 100) als Leitungselemente Leistungskabel (124) und Steuerkabel (119) und oder Stromschienen (110, 111, 112) angeordnet sind.

3. Schrank oder Gerüst nach Anspruch 1 oder 2, dadurch gekennzeichnet, daß die kastenförmigen Trägerelemente (18, 19 ; 32, 33, 34 ; 46 ; 100) als Kunststofformteile ausgebildet sind.

4. Schrank oder Gerüst nach Anspruch 2 oder 3, dadurch gekennzeichnet, daß die kastenförmigen Trägerelemente (18, 19 ; 32, 33, 34 ; 46 ; 100) in ihrem Inneren Rippen (48 ... 52 ; 105 ... 109) aufweisen, zwischen denen die Stromverteilerschienen (53, 54, 55 ; 110, 111, 112) einfügbar sind und/oder an denen die Stromverteilerschienen zu ihrer Lagefixierung anschlagen.

5. Schrank oder Gerüst nach einem der Ansprüche 1 bis 4, dadurch gekennzeichnet, daß die Trägerelemente (18, 19 ; 32, 33, 34 ; 46 ; 100) in ihrer montierten Lage zu den Stromsammelschienen (14 ... 17) gerichtete rohrartige Ausformungen (103) aufweisen, innerhalb derer elektrisch mit den Verteilerschienen (53 ... 55 ; 110 ... 112) einerseits verbundene und mit den Stromsammelschienen (14 ... 17) verbindbare Anschlußkontaktelemente, insbesondere Steckanschlußelemente (59 ... 61) anordenbar sind.

6. Schrank oder Gerüst nach einem der Ansprüche 1 bis 5, dadurch gekennzeichnet, daß die kastenförmigen Trägerelemente (18, 19 ; 32, 33, 34 ; 46 ; 100) in den Randbereichen ihrer umlaufenden Kastenwandungen Rastöffnungen (67) aufweisen, welche mit federnden Rastnasen an den zugeordneten Abdeckungen (69, 70) zusammenwirken, oder umgekehrt, daß an den genannten Kastenwandungen federnde Rastnasen angeordnet sind, welche mit entsprechenden Rastöffnungen in den Abdeckungen zusammenwirken.

7. Schrank oder Gerüst nach einem der Ansprüche 1 bis 6, dadurch gekennzeichnet, daß die kastenförmigen Trägerelemente (18, 19 ; 32, 33, 34 ; 46 ; 100) in ihrem Inneren angeformte Hülsen (80) oder eingefügte oder eingespritzte metallische Gewindehülsen zur Aufnahme von Befestigungsschrauben (79) für die Halterung oder zusätzliche Halterung der Abdeckungen (69, 70) und/oder zu deren Führung aufweisen.

8. Schrank oder Gerüst nach einem der Ansprüche 1 bis 7, dadurch gekennzeichnet, daß die Abdeckungen der einzelnen Trägerelemente (18, 19 ; 32, 33, 34 ; 46 ; 100) in Abhängigkeit von der Anzahl der in der entsprechenden Etage aufzunehmenden Einschüben von einem oder mehreren Abdeckteilen (20 ... 25 ; 35 ... 41 ; 69, 70) gebildet werden, wobei jedem der Einschübe ein gesondertes Abdeckteil zugeordnet ist.

9. Schrank oder Gerüst nach einem der Ansprüche 1 bis 8, dadurch gekennzeichnet, daß die Abdeckteile (20 ... 25 ; 35 ... 41 ; 69, 70) für die Abdeckungen der kastenförmigen Trägerelemente (18, 19 ; 32, 33, 34 : 46 ; 100) als Kunststofformteile ausgebildet sind.

10. Schrank oder Gerüst nach einem der Ansprüche 1 bis 9, dadurch gekennzeichnet, daß die Abdeckteile (20 ... 25 ; 35 ... 41 ; 69, 70) für die Abdeckungen der Trägerelemente (18, 19 ; 32, 33, 34 ; 46 ; 100) an ihren in montierter Lage oberen und/oder unteren Kanten mit Abwinkelungen bzw. entsprechenden Anformungen versehen sind, von welchen federnde Rastnasen (68) ausgehen und/oder in welchen Rastöffnungen zur Aufnahme von Rastnasen angeordnet sind, wobei diese genannten Rastnasen bzw. Rastöffnungen mit den im Anspruch 6 genannten Ausbildungen der Trägerelemente zusammenwirken.

11. Schrank oder Gerüst nach einem der Ansprüche 8 bis 10, dadurch gekennzeichnet, daß die Abdeckteile (69, 70) für die Trägerelemente (46) außer Schrauböffnungen (78) auch noch Durchtrittsöffnungen (74) für den Durchtritt von einzelnen Leistungszu- und -abgängen und wenigstens eine weitere Durchtrittsöffnung (71) für den Durchtritt und die Halterung eines vielpoligen Steckkontaktteiles (72) aufweisen.

12. Schrank oder Gerüst nach Anspruch 11, dadurch gekennzeichnet, daß die Durchtrittsöffnungen (74) für die einzelnen Leistungszu- und -abgänge von in Richtung der aufzunehmenden Einschübe vorstehenden Kragenansätzen (77) umgeben sind.

13. Schrank oder Gerüst nach einem der Ansprüche 8 bis 12, dadurch gekennzeichnet, daß die Abdeckteile (69, 70) für die Trägerelemente (46) mit Führungsöffnungen und/oder in Richtung des aufzunehmenden Einschubes vorstehenden Zapfen (73) versehen sind, welche der Führung des zugeordneten Einschubes in seiner letzten Wegstrecke seines Einschubweges dienen.

14. Schrank oder Gerüst nach einem der Ansprüche 8 bis 13, dadurch gekennzeichnet, daß die Abdeckteile (69, 70) für die Trägerelemente (46) auf ihrer dem zugeordneten Trägerelement zugekehrten Seite mit Rippen (81) zur Aufnahme und/oder zum Anschlag der Stromverteilerschienen (53 ... 55) ausgestattet sind, wobei diese Rippen Bestandteil des Formteiles sein können.

15. Schrank oder Gerüst nach den Ansprüche 4 und/oder 14, dadurch gekennzeichnet, daß zwischen den einzelnen von den Tragelementen (100) und/oder den Abdeckteilen (101) ausgehenden Rippen (105 ... 108 ; 114 ... 117) zur Aufnahme oder Lagefixierung der Stromverteilerschienen (110 ... 112), gegebenenfalls weiterer Rippen (109) und — in Randungsbereichen — den Kastenwandungen einzelne und gegeneinander weitgehend abgetrennte Kabelkanäle (118, 120 ... 123) für die separierte Aufnahme von Kabelgruppen (119, 124) gebildet sind (Fig. 4).

16. Schrank oder Gerüst nach einem der Ansprüche 1 bis 15, dadurch gekennzeichnet, daß die kastenförmigen Wandungselemente (26 ... 29 ; 42 ... 44 ; 47) als erdungsfähige Blechformteile ausgebildet sind.

17. Schrank oder Gerüst nach einem der Ansprüche 1 bis 16, dadurch gekennzeichnet, daß die kastenförmigen Wandungselemente (47) in ihrer Kastenboden-Fläche mit Ausnehmungen (83 ... 87) zur vorzugsweise rastenden Aufnahme von Steckanschlußelementen oder Anschlußklemmen (88, 89) oder zum Kabeldurchlaß (Kabel 66) zu solchen Elementen versehen sind.

18. Schrank oder Gerüst nach Anspruch 17, dadurch gekennzeichnet, daß die Ausnehmungen (83 ... 86) durch dem jeweiligen Bedarfsfall entsprechende Austrennung von einzelnen Bereichen aus der Kastenboden-Fläche herstellbar sind.

19. Schrank oder Gerüst nach einem der Ansprüche 1 bis 18, dadurch gekennzeichnet, daß von den kastenförmigen Wandungselementen (47) wenigstens eine in den freien Bereich des Kabel- und Anschlußraumes (9, 10, 12, Fig. 1) gerichtete Tragwandung ausgeht, welche der Aufnahme von weiteren Kabelanschlußelementen (Leitungsklemmen 90) oder von Tragschienen (92) für solche Anschlußelemente dient.

20. Schrank oder Gerüst nach einem der Ansprüche 1 bis 19, dadurch gekennzeichnet, daß von den kastenförmigen Wandungselementen (47) in Richtung der jeweils zugeordneten Trägerelemente (46) weisende Laschen (93) ausgehen, welche zur mechanischen Verbindung mit dem angrenzenden Trägerelement und/oder mit Tragschienen innerhalb des Schrankes bzw. Gerüstes dienen.

21. Schrank oder Gerüst nach einem der Ansprüche 1 bis 20, dadurch gekennzeichnet, daß die die kastenförmigen Wandungselemente (47) verschließenden Abdeckungen (82) als Blechteile oder als Kunststoffspritzteile ausgebildet sind und ihre Befestigung an den ihnen zugeordneten Wandungselementen mittels Rastelementen erfolgt.

**Claims**

1. Cabinet or rack for accommodating slide-in units for electrical switching, control, monitoring and distribution systems which can be arranged above each other in subracks and possibly next to one another within a subrack, with current busbars arranged in the rear area of the cabinet or rack and support elements which are located in front of the busbars, can be preassembled and are separately allocated to the individual slide-in subracks and including at least one cable and connection space which is delimited by means of wall elements with respect to the slide-in units to be accommodated and is located in a side area of the cabinet or rack, characterized in that both the support elements (18, 19 ; 32, 33, 34 ; 46 ; 100) allocated to the individual slide-in subracks and the wall elements (26 ... 29 ; 42, 43, 44 ; 47) delimiting the cable and connection space (9, 10, 12) with respect to the slide-in units to be accommodated exhibit a box-shaped formation used for accommodating electric line elements and are equipped with covers (20 ... 25 ; 30, 31 ; 35 ... 41 ; 69, 70 ; 82 ; 101) which essentially close off the interior of the box, that at least one separate box-shaped wall element is associated with each box-shaped support element and that the box-shaped elements arranged in a common subrack are joined together at right angles to one another and abutting in their position with regard to their longitudinal extension mounted in the cabinet (8) or in the rack, respectively, in which arrangement recesses (65, 95) within both abutting box wall areas form passage openings for the passage of the line elements from the interior of the support element into the interior of the associated wall elements.

2. Cabinet or rack according to Claim 1, characterized in that line cables (124) and control cables (119) and/or busbars (110, 111, 112) are arranged as line elements in the interior of the box-shaped support elements (18, 19 ; 32, 33, 34 ; 46 ; 100).

3. Cabinet or rack according to Claim 1 or 2, characterized in that the box-shaped support elements (18, 19 ; 32, 33, 34 ; 46 ; 100) are constructed as moulded plastic parts.

4. Cabinet or rack according to Claim 2 or 3, characterized in that the box-shaped support elements (18, 19 ; 32, 33, 34 ; 46 ; 100) have in their interior ribs (48 ... 52 ; 105 ... 109) between which the current distribution rails (53, 54, 55 ; 110, 111, 112) can be inserted and/or at which the current distribution rails stop to fix their position.

5. Cabinet or rack according to one of Claims 1 to 4, characterized in that the support elements (18, 19 ; 32, 33, 34 ; 46 ; 100) have tubular moulded projections (103) which are directed towards the current busbars (14 ... 17) in their mounted position and within which connection contact elements, particularly plug-in connection elements (59 ... 61) which, on the one hand, are electrically connected to the distribution rails (53 ... 55 ; 110 ... 112) and can be connected to the current busbars (14 ... 17) can be arranged.

6. Cabinet or rack according to one of Claims 1 to 5, characterized in that the box-shaped support elements (18, 19 ; 32, 33, 34 ; 46 ; 100) have in the edge regions of their peripheral box walls detent openings (67) which act in conjunction with elastic detent noses on the associated covers (69, 70) or vice versa, that elastic detent noses are arranged on the said box walls which work in conjunction with corresponding detent openings in the covers.

7. Cabinet or rack according to one of Claims 1 to 6, characterized in that the box-shaped support elements (18, 19 ; 32, 33, 34 ; 46 ; 100) have in their interior moulded-on sleeves (80) or inserted or injection-moulded metallic threaded sleeves for accommodating mounting screws (79) for the attachment or additional attachment of the covers (69, 70) and/or as guide for these.

8. Cabinet or rack according to one of Claims 1 to 7, characterized in that the covers of the individual support elements (18, 19 ; 32, 33, 34 ; 46 ; 100) are formed of one or more cover parts (20 ... 25 ; 35 ... 41 ; 69, 70) in dependence on the number of the slide-in units to be accommodated in the corresponding subrack, a separate cover part being associated with each of the slide-in units.

9. Cabinet or rack according to one of Claims 1 to 8, characterized in that the cover parts (20 ... 25 ; 35 ... 41 ; 69, 70) for the covers of the box-shaped support elements (18, 19 ; 32, 33, 34 ; 46 ; 100) are constructed as moulded plastic parts.

10. Cabinet or rack according to one of Claims 1 to 9, characterized in that the cover parts (20 ... 25 ; 35 ... 41 ; 69, 70) for the covers of the support elements (18, 19 ; 32, 33, 34 ; 46 ; 100) are provided with angles or corresponding integral mouldings at their edges which are the upper and/or lower edges in the mounted position, from which edges elastic detent noses (68) project and/or in which detent openings for accommodating detent noses are arranged, these said detent noses or detent openings working in conjunction with the formations of the support elements mentioned in Claim 6.

11. Cabinet or rack according to one of Claims 8 to 10, characterized in that the cover parts (69, 70) for the support elements (46), in addition to screw openings (78), also have passage openings (74) for the passage of individual input and output lines and at least one further passage opening (71) for the passage and mounting of a multi-pin plug-in contact part (72).

12. Cabinet or rack according to Claim 11, characterized in that the passage openings (74) for the individual input and output lines are surrounded by stub collars (77) projecting in the direction of the slide-in units to be accommodated.

13. Cabinet or rack according to one of Claims 8 to 12, characterized in that the cover parts (69, 70) for the support elements (46) are provided with guide openings and/or pegs (73) which project in the direction of the slide-in unit to be accommodated and which are used for guiding the associated slide-in unit in the last stretch of its slide-in path.

14. Cabinet or rack according to one of Claims 8 to 13, characterized in that the cover parts (69, 70) for the support elements (46) are provided on their side facing the associated support element with ribs (81) for accommodating and/or as stop for the current distribution rails (53 ... 55), in which arrangement these ribs can be a component part of the moulded part.

15. Cabinet or rack according to Claims 4 and/or 14, characterized in that, between the individual ribs (105 ... 108 ; 114 ... 117) for accommodating or fixing the position of the current distribution rails (110 ... 112), projecting from the support elements (100) and/or the cover parts (101), possibly further ribs (109) and, in edge regions, the box walls, individual cable ducts (118, 120 ... 123) which are largely separated from each other, for the separated accommodation of cable groups (119, 124) are formed (Figure 4).

16. Cabinet or rack according to one of Claims 1 to 15, characterized in that the box-shaped wall elements (26 ... 29 ; 42 ... 44 ; 47) are constructed as moulded steel plate parts which are capable of being earthed.

17. Cabinet or rack according to one of Claims 1 to 16, characterized in that the box-shaped wall elements (47) are provided with recesses (83 ... 87) in their box bottom area for the preferably locking accommodation of plug-in connection elements or connection terminals (88, 89) or for allowing a cable (cable 66) to pass through to such elements.

18. Cabinet or rack according to Claim 17, characterized in that the recesses (83 ... 86) can be produced by separating individual areas out of the box bottom area as required in each case.

19. Cabinet or rack according to one of Claims 1 to 18, characterized in that at least one support wall directed into the free area of the cable and connecting space (9, 10, 12, Figure 1) projects from the box-shaped wall elements (47) and is used for accommodating further cable connection elements (line terminals 90) or support rails (92) for such connection elements.

20. Cabinet or rack according to one of Claims 1 to 19, characterized in that lugs (93) project from the box-shaped wall elements (47) in the direction of the associated support elements (46) in each case, which lugs are used for the mechanical connection with the adjoining support element and/or with support rails within the cabinet or rack.

21. Cabinet or rack according to one of Claims 1 to 20, characterized in that the covers (82) closing off the box-shaped wall elements (47) are constructed as steel plate parts or as injection-moulded plastic parts and are mounted by means of detent elements on the wall elements associated with them.

**Revendications**

1. Armoire ou charpente pour recevoir des tiroirs, pouvant être superposés en étages et placés éventuellement les uns à côté des autres dans un étage, pour installations électriques de commutation, de commande, de surveillance et de distribution, avec barres omnibus installées dans la zone arrière de l'armoire ou de la charpente, ainsi que des éléments-supports préalablement montés en avant et associés séparément aux différents étages de tiroirs et avec au moins un local d'entrée des câbles et des raccordements disposé dans une zone latérale de l'armoire ou de la charpente et délimité, du côté des tiroirs à recevoir, au moyen d'éléments de parois, caractérisée par le fait qu'aussi bien les éléments-supports (18, 19 ; 32, 33, 34 ; 46 ; 100), associés aux différents étages de tiroirs, que les éléments de parois (26 ... 29 ; 42, 43, 44 ; 47), délimitant le local d'entrée des câbles et des raccordements (9, 10, 12) du côté des tiroirs à recevoir, ont une configuration en forme de caisson servant à recevoir des conducteurs électriques et sont pourvus de couvercles (20 ... 25 ; 30, 31 ; 35 ... 41 ; 69, 70 ; 82 ; 101) fermant l'intérieur du caisson, qu'à chaque élément-support en forme de caisson est associé au moins un élément de paroi en forme de caisson séparé et que les éléments en forme de caissons disposés dans un étage commun sont assemblés jointifs et mutuellement à angle droit par rapport à leur longueur dans leur position montée dans l'armoire (8) ou la charpente, des évidements (65, 95) à l'intérieur de deux zones de parois jointives du caisson formant des ouvertures pour le passage des conducteurs allant de l'intérieur de l'élément-support à l'intérieur des éléments de parois y associés.

2. Armoire ou charpente selon la revendication 1, caractérisée par le fait que, comme conducteurs, des câbles de puissance (124) et des câbles de commande (119) et/ou des barres omnibus (110, 111, 112) sont disposés à l'intérieur des éléments-supports (18, 19 ; 32, 33, 34 ; 46 ; 100) en forme de caissons.

3. Armoire ou charpente selon la revendication 1 ou 2, caractérisée par le fait que les éléments-supports (18, 19 ; 32, 33, 34 ; 46 ; 100) en forme de caissons sont réalisés sous la forme de préformés en matière synthétique.

4. Armoire ou charpente selon la revendication 2 ou 3, caractérisée par le fait que les éléments-supports (18, 19 ; 32, 33, 34 ; 46 ; 100) en forme de caissons comportent à l'intérieur des nervures (48 ... 52 ; 105 ... 109) entre lesquelles sont insérées les barres omnibus (53, 54, 55 ; 110, 111, 112) et/ou contre lesquelles les barres omnibus viennent buter pour leur fixation en position.

5. Armoire ou charpente selon l'une des revendications 1 à 4, caractérisée par le fait que les éléments-supports (18, 19 ; 32, 33, 34, 46 ; 100) comportent des évidements tubulaires (103) dirigés vers les barres omnibus (14 ... 17) à leur état monté et à l'intérieur desquels sont disposés des éléments de contact, en particulier des prises de courant embrochables (59 ... 61) raccordées électriquement aux barres omnibus (53 ... 55 ; 110 ... 112) d'un côté et pouvant être raccordées aux barres omnibus (14 ... 17).

6. Armoire ou charpente selon l'une des revendications 1 à 5, caractérisée par le fait que les éléments-supports (18, 19 ; 32, 33, 34 ; 46 ; 100) en forme de caissons comportent, dans les zones marginales de leurs parois entourant le caisson, des ouvertures d'encliquetage (67) qui coopèrent avec des ergots d'encliquetage élastiques placés sur les couvercles (69, 70) y associés ou, inversement, que sur les parois précitées du caisson sont aménagés des ergots d'encliquetage élastiques qui coopèrent avec des ouvertures correspondantes pratiquées dans les couvercles.

7. Armoire ou charpente selon l'une des revendications 1 à 6, caractérisée par le fait que les éléments-supports (18, 19 ; 32, 33, 34 ; 46 ; 100) en forme de caissons comportent des douilles (80) façonnées d'une seule pièce à l'intérieur ou des douilles taraudées métalliques emboîtées ou incorporées par injection pour recevoir des vis (79) prévues pour la fixation ou la fixation supplémentaire des couvercles (69, 70) et/ou pour leur guidage.

8. Armoire ou charpente selon l'une des revendications 1 à 7, caractérisée par le fait que les couvercles des différents éléments-supports (18, 19 ; 32, 33, 34 ; 46 ; 100) sont formés par un ou plusieurs couvercles (20 ... 25 ; 35 ... 41 ; 69, 70) en fonction du nombre de tiroirs que doit recevoir l'étage correspondant, un couvercle séparé étant associé à chacun des tiroirs.

9. Armoire ou charpente selon l'une des revendications 1 à 8, caractérisée par le fait que les couvercles (20 ... 25 ; 35 ... 41 ; 69, 70), recouvrant les éléments-supports (18, 19 ; 32, 33, 34 ; 46 ; 100) en forme de caissons, sont réalisés sous forme de préformés en matière synthétique.

10. Armoire ou charpente selon l'une des revendications 1 à 9, caractérisée par le fait que les couvercles (20 ... 25 ; 35 ... 41 ; 69, 70) recouvrant les éléments-supports (18, 19 ; 32, 33, 34 ; 46 ; 100) sont munis, sur leurs arêtes supérieure et/ou inférieure à l'état monté, de pliures ou de déformations correspondantes d'où partent des ergots d'encliquetage élastiques (68) et/ou dans lesquelles sont pratiquées des ouvertures pour recevoir des ergots d'encliquetage, ces ergots ou ces ouvertures précités coopérant avec les configurations, énoncées à la revendication 6, des éléments-supports.

11. Armoire ou charpente selon l'une des revendications 8 à 10, caractérisée par le fait que les couvercles (69, 70) pour les éléments-supports (46), en plus des ouvertures (78) pour les vis, comportent également des ouvertures (74) pour le passage de différentes entrées et sorties de puissance et au moins une autre ouverture (71) pour le passage et la fixation d'un élément de contact embrochable multipolaire (72).

12. Armoire ou charpente selon la revendication 11, caractérisée par le fait que les ouvertures (74) pour le passage des différentes entrées et sorties de puissance sont entourées d'appendices (77) en forme de collerettes faisant saillie en direction des tiroirs à recevoir.

13. Armoire ou charpente selon l'une des revendications 8 à 12, caractérisée par le fait que les couvercles (69, 70) pour les éléments-supports (46) sont munis d'ouvertures de guidage et/ou de tétons (73) qui font saillie en direction du tiroir à recevoir et qui servent au guidage du tiroir y associé dans le dernier tronçon de sa course d'enfoncement.

14. Armoire ou charpente selon l'une des revendications 8 à 13, caractérisée par le fait que les couvercles (63, 70) Pour les éléments-supports (46), sur leur côté tournée vers l'élément-support y associé, sont munis de nervures (81) pour recevoir les barres omnibus (53 ... 55) et/ou leur servir de butée, ces nervures pouvant faire partie intégrante du préformé.

15. Armoire ou charpente selon les revendications 4 et/ou 14, caractérisée par le fait qu'entre les différentes nervures (105 ... 108 ; 114 ... 117) partant des éléments-supports (100) et/ou des couvercles (101) et destinés à recevoir ou à fixer en position les barres omnibus (110 ... 112) et, éventuellement, entre d'autres nervures (109) et — dans les zones des bords — les parois des caissons, sont formés différents canaux de câbles (118, 120 ... 123) largement cloisonnés les uns par rapport aux autres pour recevoir séparément des groupes de câbles (119, 124) (figure 4).

16. Armoire ou charpente selon l'une des revendications 1 à 15, caractérisée par le fait que les éléments de parois (26 ... 29 ; 42 ... 44 ; 47) en forme de caissons sont réalisés sous forme de préformés en tôle pouvant être mis à la terre.

17. Armoire ou charpente selon l'une des revendications 1 à 16, caractérisée par le fait que les éléments de parois (47) en forme de caissons dans leur surface du fond sont munis d'évidements (83 ... 87) pour la fixation, de préférence par encliquetage, de prises de courant embrochables ou de bornes de raccordement (88, 89) ou pour le passage de câbles (câble 66) allant à de telles prises de courant.

18. Armoire ou charpente selon la revendication 17, caractérisée par le fait que les évidements (83 ... 88) sont fabriqués par enlèvement, correspondant au besoin à chaque fois considéré, de différentes zones de la surface du fond du caisson.

19. Armoire ou charpente selon l'une des revendications 1 à 18, caractérisée par le fait que des éléments de parois (47) en forme de caissons portent au moins une paroi portante qui est dirigée dans la zone libre du local d'entrée des câbles et des raccordements (9, 10, 12, figure 1) et servent à recevoir d'autres raccords de câbles (bornes de lignes 90) ou des profilés-supports (92) pour de tels raccords de câbles.

20. Armoire ou charpente selon l'une des revendications 1 à 19, caractérisée par le fait que des éléments de parois (47) en forme de caissons partent des languettes (93) qui sont orientées en direction des éléments-supports (46) à chaque fois y associés et qui servent au raccordement mécanique à l'élément-support limitrophe et/ou aux profilés-supports à l'intérieur de l'armoire ou de la charpente.

21. Armoire ou charpente selon l'une des revendications 1 à 20, caractérisée par le fait que les couvercles (82) fermant les éléments de parois (47) en forme de caissons sont réalisés sous la forme de pièces en tôle ou de pièces en matière synthétique moulées par injection et que leur fixation sur les éléments de parois qui leur sont associés s'effectue au moyen d'éléments d'encliquetage.

Fig.1

1

Fig.2

Fig.3

Fig.4